Europäisches Patentamt

(19) European Patent Office

Office européen des brevets

(11) Publication number : **0 450 837 A2**

# (12) EUROPEAN PATENT APPLICATION

(21) Application number : **91302627.4**

(51) Int. Cl.⁵ : **G06F 15/60**

(22) Date of filing : **26.03.91**

(30) Priority : **30.03.90 US 502089**

(43) Date of publication of application :
**09.10.91 Bulletin 91/41**

(84) Designated Contracting States :
**DE FR GB**

(71) Applicant : **International Business Machines
Corporation
Old Orchard Road
Armonk, N.Y. 10504 (US)**

(72) Inventor : **Sweet, Mark David
5906 Trabadora Cove
Austin, Texas 78759 (US)**
Inventor : **Wright, Charles Gordon
1204 Woodrock
Round Rock, Texas 78681 (US)**

(74) Representative : **Killgren, Neil Arthur
IBM United Kingdom Limited Intellectual
Property Department Hursley Park
Winchester Hampshire SO21 2JN (GB)**

(54) Logic simulation.

(57) A logic simulation machine comprises a plurality of simulation processors for executing logic simulation in parallel, and simulation bus means for connecting the simulation processors to each other. The simulation bus means includes a plurality of data lines allocated to each of the simulation processors so that each of the simulation processors puts information in parallel on the allocated data lines. Each of the simulation processors keeps a complete copy of current states of a model being simulated by updating the copy with the information from the data lines. An auxiliary processor is connected to the simulation bus means to receive the information to accelerate the simulation. A host interface is provided for connecting the simulation bus means to a host computer.

EP 0 450 837 A2

FIG. 1A

FIG. 1B

The present invention relates to logic simulation using a parallel computer for the simulation of digital logic.

Logic technologies such as very large scale integrated circuits provide significant improvememts in cost/performance and reliability. However, they have disadvantages in that their fault diagnosis is more difficult than previous technologies and the engireering rework cycles needed to correct faults in logic design are greatly lengthened. These disadvantages exact great economic penalties for design errors and omissions and place a great emphasis on the goal of completely verifying designs in advance of engineering models.

One technique for providing design verification is logic simulation by a general purpose computer. Another technique is to use a special purpose computer that is optimised for logic simulation. The special purpose computer usually uses a multiple processor architecture by which a number of processors, called simulation processors, may be interconnected to improve simulation performance. The special purpose computer may operate in combination with a host computer which is used to provide loading functions and to analyse the results of the simulation. Such a special purpose computer is called a logic simulation machine.

An example of a logic simulation machine is described in U.S. Pat. No. 4,306,286 issued December 15, 1981, to Cocke et al. This machine comprises a plurality of parallel basic processors which are interconnected through an inter-processor switch. The inter-processor switch provides communication not only among the basic processors which are computing engines of the logic simulation machine, each simulating the individual gates of a portion of a logic model in parallel, but also between them and a control processor which provides overall control and input/output facilities of the logic simulation machine through a host computer to which the control processor is attached.

Although this machine is capable of parallel processing, the basic processors require the inter-processor switch to be set in order to communicate with each other and with the host computer. Each basic processor contains the current state information for only the set of gates that is being simulated by that processor. When a basic processor simulates a gate whose input includes a connection to the output of a gate being simulated by a different processor, the state information for the gate in question is transferred over the inter-processor switch. The compilation of a logic model to be simulated thus becomes a time-consuming operation since it involves the difficult job of finding logical partitions and scheduling transfers in the switch-based architecture. Moreover, once the configuration of the basic processors is changed, the logic model to be simulated must be recompiled as well so as to meet the changed configuration.

Accordingly, it is an object of the present invention to provide a logic simulation machine and a method of logic simulation which permits faster simulation than hitherto.

According to the invention there is provided a logic simulation machine comprising: a plurality of simulation processors for executing logic simulation in parallel characterised by a simulation bus connecting the simulation processors to each other, the simulation bus including a plurality of data lines allocated to each of the simulation processors for parallel transfer of information from each of the simulation processors.

There is further provided a machine as claimed in any preceding claim in which said simulation bus is physically configured to provide a plurality of slots into which the simulation processors are plugged, and includes a plurality of configuration lines energisable to identify each of the simulation processors with a performed slot.

In a preferred embodimemt of the invention, each simulation processor, includes a first memory unit, a second memory unit, and a logical function table. Instructions necessary to specify operations of each of the simulation processors are stored in the first memory unit of each of the simulation processors. Initial states of a whole model to be simulated are stored in the second memory unit of each of the simulation processors. The first memory unit is addressed to output a stored instruction and the second memory unit is addressed using the instruction from the first memory unit to output the stored states in each of the simulation processors. A result is calculated from the outputted instruction and the outputted states in the logical function table in each of the simulation processors and is transferred to; all simulation processors over the simulation bus. The second memory unit is updated with the results on the simulation bus in each of the simulation processors so that all of the second memory units in the simulation processors store the same current states of the whole model being simulated.

The number the simulation processors is preferably selected from a group consisting of 1, 2, 4, 8, 16, and M (M is a maximum number in the group and $M=2^n$, n is an integer) and may be changed by a user depending on a desired performance at any time. A model is compiled by assigning block description instructions of a model to be simulated to each of the simulation processors in an instruction list to be sent to the simuilation processors before simulation so that the block description instructions begin at a first simulation processor, proceed to an Mth processor, and then back to the first processor to repeat the above sequence in the instruction list, and inserting a set of M identical control instructions at a location beginning at k x M (k is an integer) in the instruction list.

## Brief Description of the Drawing

In order that the invention may be well understood, a preferred embodiment thereof will now be described with reference to the accompanying drawings, in which:-

Fig. 1 is an entire schematic block diagram of a logic simulation machine according to a preferred embodiment of the present invention with a host computer to which the machine is attached.

Fig. 2 is a schematic block diagram of the simulation processor plugged into the slot 0 in Fig. 1.

Fig. 3 is a schematic diagram showing contents of a block description array of the simulation processor of Fig. 2.

Fig. 4 is a schematic diagram showing the op-code field of instructions stored in the block description array of Fig. 3.

Fig. 5 is a schematic block diagram of a simplified logic circuit model used in explaining a block description instruction and operation of the simulation processor shown in Fig. 2.

Fig. 6 is a schematic block diagram of a current state array of the simulation processor of Fig. 2.

Fig. 7 is a detailed schematic block diagram of a part of the simulation processor of Fig.2.

Fig. 8 is a schematic block diagram of an outputting means of the simulation processor of Fig. 2 for putting a result from a logic function table on allocated data lines of the simulation bus.

Fig. 9 is a schematic diagram showing a method of compiling a model to be loaded into and simulated by the logic simulation machine of Fig. 1 according to the invention.

Fig. 10 is a simplified illustration of the block description arrays of the simulation processors in the machine of Fig. 1 to explain operation of the machine.

Fig. 11 is a simplified illustration of the block description arrays of another configuration of the logic simulation machine of the invention.

Fig. 12 is a schematic block diagram of an all events trace gatherer which is connected to the simulation bus means in parallel with the simulation processors to generate an all events trace (AET) in parallel with the simulation.

Fig. 13 is a schematic diagram of a 2-bit counter to be simulated by the machine of Fig. 1 to explain operation of the all events trace gatherer of Fig. 12.

Fig. 14 is a table to explain current states of nodes in the counter of Fig. 13 at each simulation cycle.

Fig. 15 is a table showing contents of a change record array to explain the operation of the all events trace gatherer of Fig. 12.

## Best Mode for Carrying Out the Invention

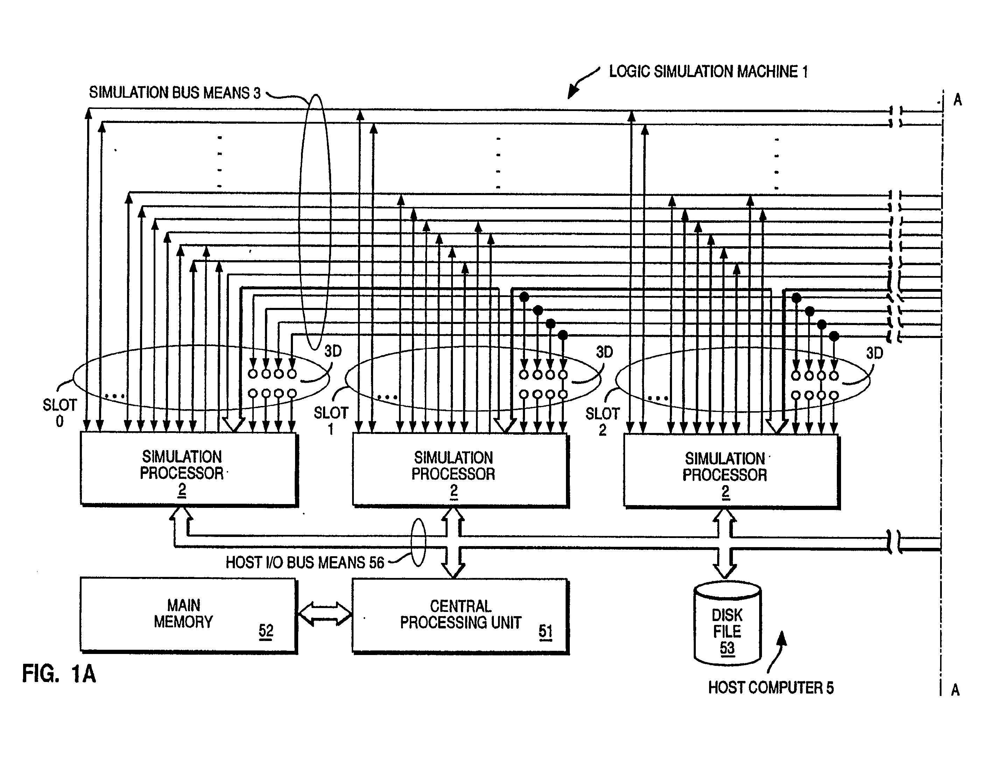

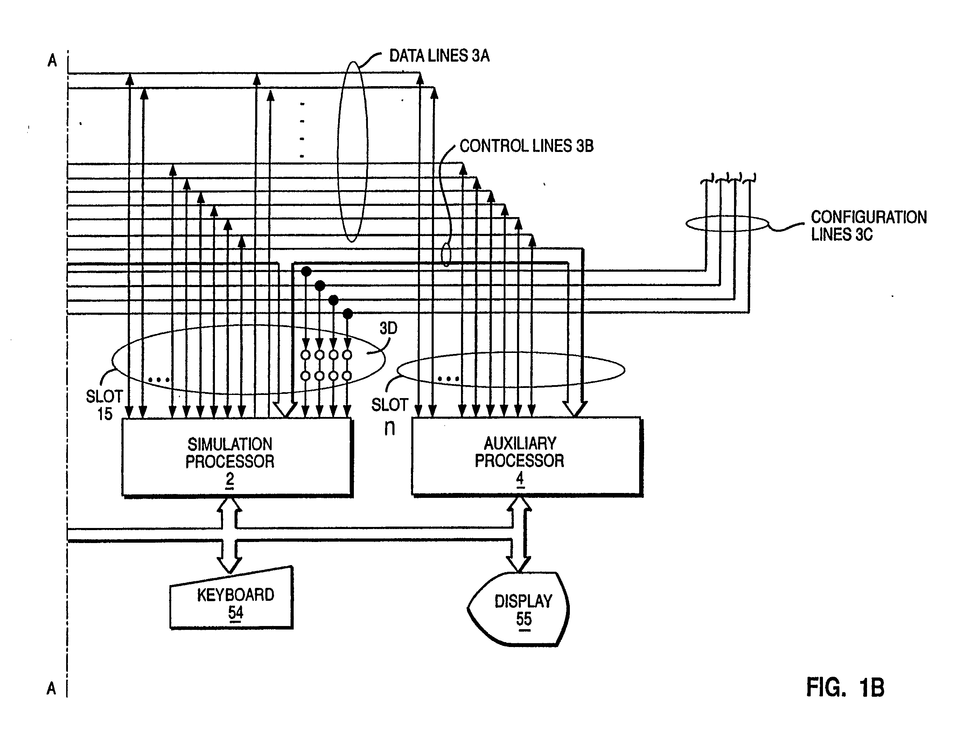

Referring to the block diagram of Fig. 1, a logic simulation machine 1 according to a preferred embodiment of the invention is explained. The logic simulation machine 1 comprises plural simulation processors 2 connected to each other in parallel through a simulation bus means 3. Although four simulation processors 2 are shown in Fig. 1, the number of the simulation processors 2 connected to the simulation bus means 3 is sixteen and sixteen processors are a maximum configuration in this embodiment for explanation purpose. However, any number of simulation processors selected from a group consisting of 1, 2, 4, 8, and 16 is able to be used in this embodiment.

The simulation bus means 3 comprises three parts: data lines 3A through which each simulation processor 2 transfers a simulated result and each simulation processor 2 receives the results from all simulation processors 2 to update its own copy of current states when evaluating gates and through which a host computer 5 transfers packet data to and from the simulation processors 2 when not evaluating gates; control lines 3B through which current contents on the data lines 3A are indicated and arbitration for the bus 3 is done; and configuration lines 3C through which a unique code is transferred to each of the simulation processors 2 to inform the configuration of the simulation processors. The simulation bus means 3 further comprises slot means 0, 1, 2,..., 15 and n. Each simulation processor 2 is plugged into the slot means 0, 1, 2,..., or 15 for connection with the simulation bus means 3. Each slot means 0, 1, 2,..., or 15 of the simulation bus means 3 has a hard wired means 3D associated with the configuration lines 3C. The number of the configuration lines 3C depends on how many simulation processors 2 the logic simulation machine 1 can contain. In this embodiment, the number of the lines 3C is four to convey a different 4-bit binary data to each of the sixteen simulation processors. The hard wired means 3D of the slot means 0 sets all lines of the configuration lines 3C OFF so that the configuration lines 3C input 4-bit binary zero data 0000 into the simulation processor 2 plugged into the slot means 0. The hard wired means 3D of the slot means 1 sets the least significant bit line ON and the other three lines OFF so that the configuration lines 3C input binary data 0001 into the simulation processor 2 plugged into that slot means. The hard wired means 3D of the slot means 2 sets the second least significant bit line ON and the other three lines OFF so that the configuration lines 3C input binary data 0010 into the simulation processor 2 plugged into that slot means and so or. The hard wired means 3D of the slot means 15 sets all lines ON so that the configuration lines 3C input binary data 1111 into the simulation processor 2 plugged into that slot means.

An auxiliary processor 4 which is an all events trace (AET) gatherer may be plugged into the slot means n of the bus means 3 for connection with the simulation bus means 3 in parallel with the simulation processors 2.

The number of the data lines 3A depends on how many simulation processors 2 the logic simulation machine 1 can contain and how many bits each simulation processor 2 needs to represent a calculated result. In this embodiment, the machine 1 can contain up to sixteen simulation processors 2 and each simulation processor 2 calculates a 2-bit result. Therefore, the number of the data lines 3A is 16 x 2 = 32. Each of the simulation processors 2 is allocated two data lines 3A to transfer a result calculated by that processor to all of the simulation processors 2, depending upon which slot means that processor 2 occupies as explained later. The data lines 3A can also be used by the host computer 5 to load data and instructions into each of the simulation processors 2 and the AET gatherer 4 before simulation and to receive the results calculated by the simulation processors 2 during the simulation through a host interface provided in one of the simulation processors 2 as explained later.

The host computer 5 may be a conventional engineering workstation. The host computer 5 includes a central processing unit 51, a main memory 52, a disk file (direct access storage device) 53, a keyboard 54, a display 55, and a host I/O bus means 56. Each of the simulation processors 2 and the AET gatherer 4 are connected to the host computer 5 through the I/O bus means 56 by being plugged into slot means (not shown) of the I/O bus means 56. If the number of the simulation processors 2 exceeds the number of the I/O slot means provided within the host computer 5, an extension housing may be used to connect the additional simulation processors to the host computer 5.

The simulation processors 2 and the auxiliary processor 4 are provided on rectangular cards. Connector (not shown) for the slot (not shown) of the host I/O bus means 56 is provided at one end of the card on which the simulation processor 2 or the auxiliary processor 4 is mounted. Connector (not shown) for the slot means 0, 1, ..., 15 or n of the simulation bus means 3 is provided at the opposite end of the card. The simulation processors 2 and the auxiliary processor 4 are installed in the host 5 by directly plugging the connector (not shown) at the one end of the card into the slot (not shown) of the host I/O bus 56. The simulation bus means 3 connects the simulation processors 2 and the auxiliary processor 4 by plugging its slot means 0 thru n into the connectors (not shown) at the opposite end of the cards.

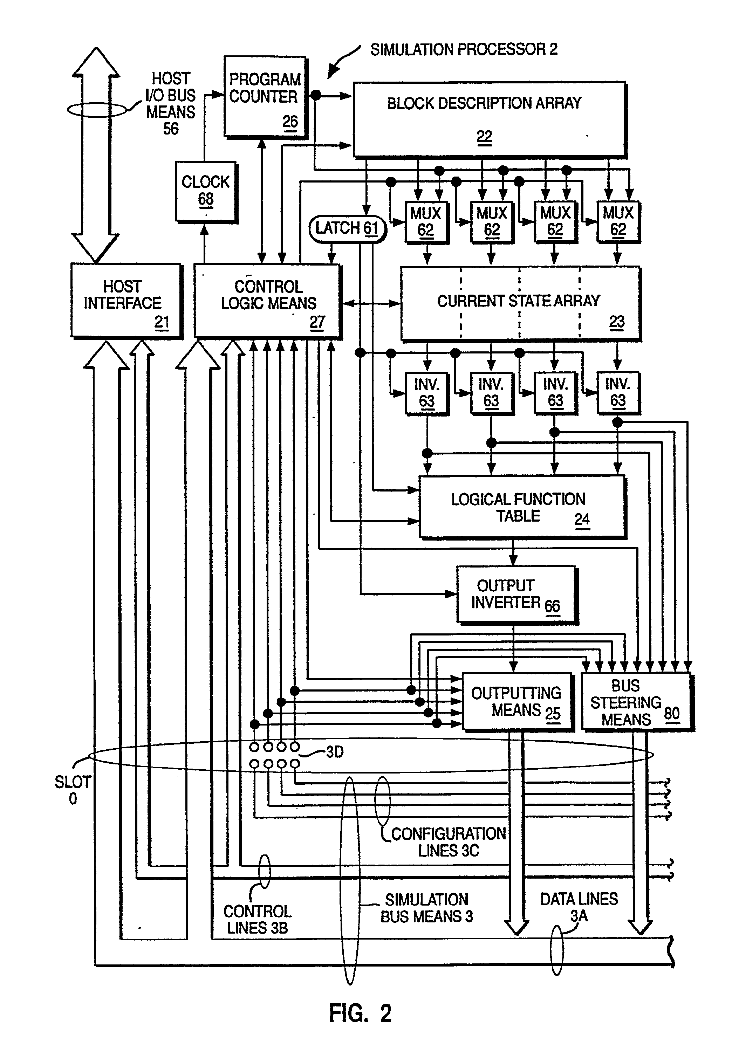

Now, referring to Fig. 2, the structure of the simulation processor 2 plugged into the slot means 0 of the simulation bus means 3 is explained. Other simulation processors 2 have the same structure except a host interface 21. Each simulation processor 2 has seven primary elements: a first memory unit, such as a block description array 22; a second memory unit, such as a current state array 23; a logical function table 24; an outputting means 25; a bus steering means 80; a program counter 26; and a control logic means 27.

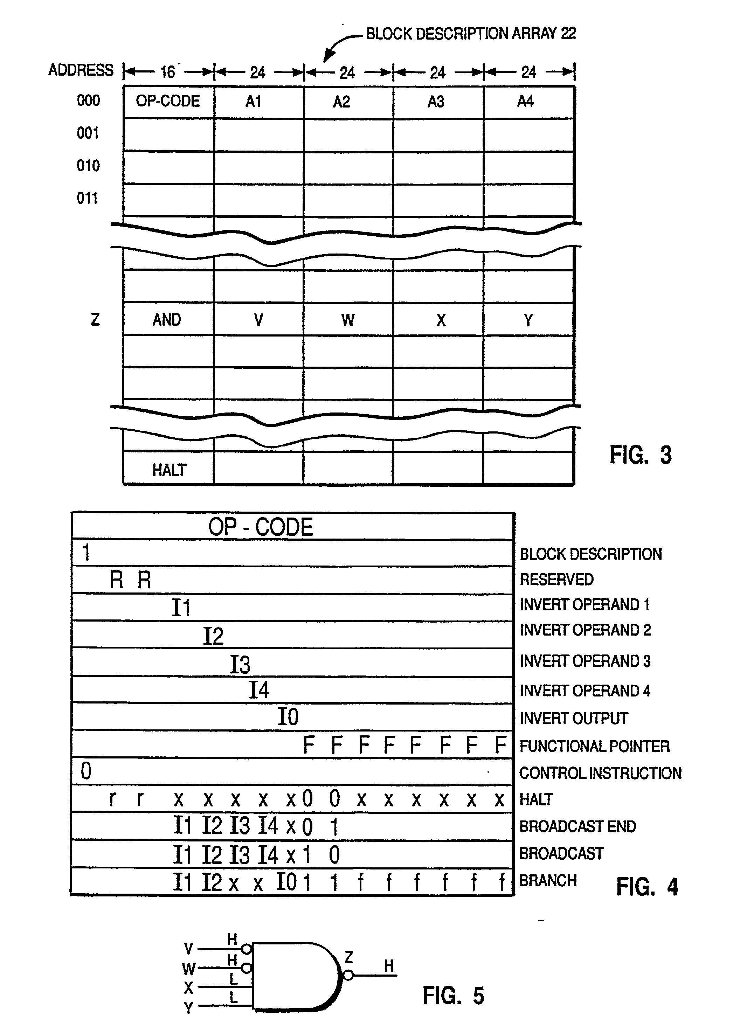

The block description array 22 is an instruction memory for the simulation processor 2 which contains all of the information necessary to specify operations of that simulation. Fig. 3 shows contents of the block description array 22. An instruction stored at one address in the array 22 contains an op-code field (16 bits), A1, A2, A3, and A4 fields (each 24 bits in this embodiment). There are two kinds of instructions determined by the op-code field as shown in Fig.4, that is, a block description instruction having a binary one at a first bit position of the op-code field for evaluating a gate and a control instruction having a binary zero at the first bit position of the op-code field for controlling operation of that simulation processor.

As to the block description instruction, one instruction word corresponds to each logical block or gate in a model to be simulated. The instruction word's address represents a block or gate identifier. The instruction contains the op-code field, to specify a logical function of the gate, such as AND or OR, and four fields A1, A2, A3 and A4, to specify input connections or input operands of the gate. Thus, a block description instruction corresponds to a single 1-output, 4-input gate. The logical function of the gate is determined by an 8-bit function pointer FFFFFFFF in the op-code which is an index to the logical function table 24. Input/output inversion can be done independent of the logical function table 24 by inversion bits I1, I2, I3, I4, and I0 in the op-code. The fields A1, A2, A3, and A4 represent addresses in the current state array 23 where the four input operands are stored. The block description instruction's address in the block description array 22 implies its output address in the current state array 23 where the calculated result is to be stored. The size of the block description array 22 depends on a desired capacity of the simulation processors 2. In this embodiment, the array 22 can store up to 512 K block description instructions.

Fig. 5 shows an example of a gate to be simulated by the simulation processor 2 in order to illustrate the block description instruction shown at an address Z in Fig. 3. An AND gates is identified by a numeral Z which corresponds to an address in the block description array 22 where the block description instruction of the gate is stored. The AND function pointer and the inversion functions of the gate are stored in the op-code field of the instruction. Input connections V, W, X, and Y of this gate are stored in the fields A1, A2, A3 and A4 of the instruction. The current state array 23 stores input operands of the gate Z at addresses V, W, X, and Y designated by the fields A1, A2, A3, and A4.

As to control instructions, the op-code field specifies control functions executed by the simulation processors. As shown in Fig. 4, Halt means to stop the simulation to wait for host interaction. Broadcast means to send any packet of data to the simulation bus means 3 for use by the host and/or an auxiliary processor connected to the simulation bus 3. Branch means to go to an instruction stored in the address designated by the fields A2 and A3.

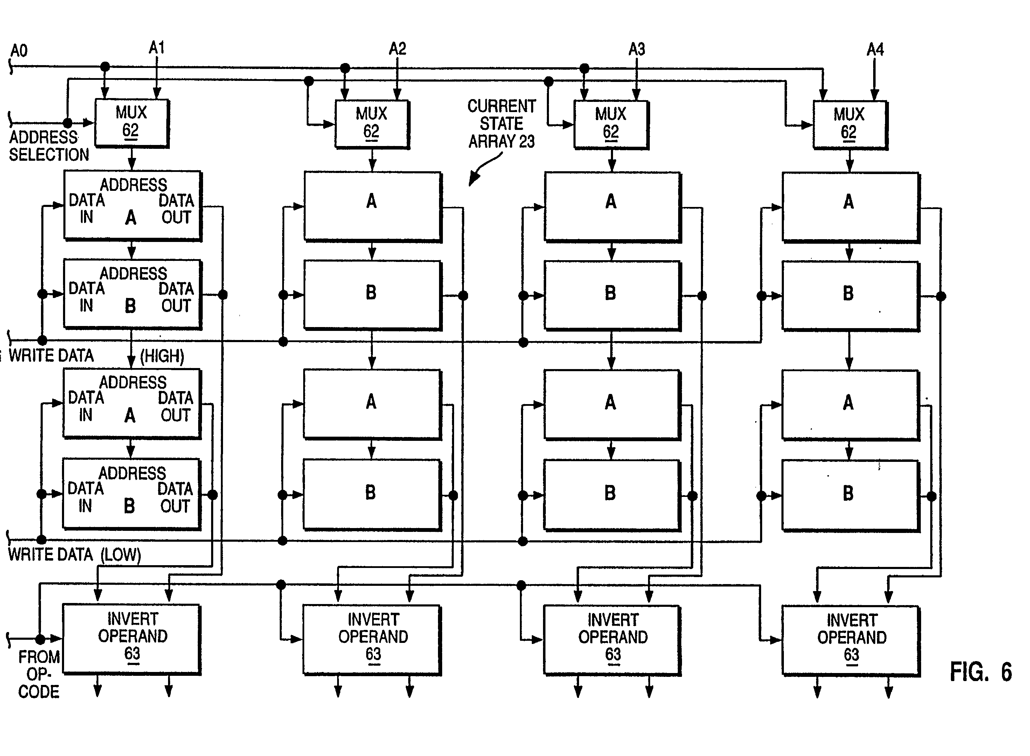

Referring to Fig. 6, the current state array 23 is explained. The current state array 23 is a memory which stores a complete copy of current states of a whole model being simulated. The state of each block or gate is specified by 2 bits. The possible states are logical 0 (00), logical 1 (01), Undefined (10) and High Impedance (11). The current state array 23 stores such current states of all blocks or gates of the machine being simulated. There are 512 K possible blocks or gates in the machine being simulated in this embodiment, so the state of the machine being simulated is contained in 1 M bits. The current state array 23 must have 1 M bit capacity at least. In the preferred embodiment, however, the current state array 23 is larger to achieve maximum performance. In the computation for a given block or gate, the contents of the current state array 23 are simultaneously addressed by the four fields A1, A2, A3 and A4. It is preferred to read the current states of four different blocks or gates simultaneously. Therefore, the array 23 is replicated 4 times. When reading the array 23, four different addresses can be read simultaneously. When writing the array 23, the same address in all four arrays is always written. That is, when the current state array 23 is read, the multiplexors 62 are controlled through an address selection by the control logic means 27 to output addresses A1, A2, A3, and A4 to each array. Then, each array outputs a 2-bit operand to an operand invert logic means 63. Each of the outputted operands may be inverted by the inversion bit of the op-code in the means 63 before calculation in the logical function table 24. When the current state array 23 is written, the multiplexors 62 are controlled through the address selection by the control logic means 27 to output one address A0. Then, the same data is written into the four arrays at the same address A0. Of course, this could been done using a single array and time-slicing, but at the expense of roughly 4 times performance. Furthermore, another 4 arrays are added in the embodiment shown in Fig. 6. For unit delay simulation, the state of the machine being simulated need to be saved in a "master-slave" arrangement. That is, the complete next state of the machine needs to be computed before this becomes the current state of the machine. The simplest way to implement this is with two memory (A and B) operating in a ping-pong arrangement. When A contains the current state, B will be used to save the next state. When B contains the current state, A is used to save the next state.

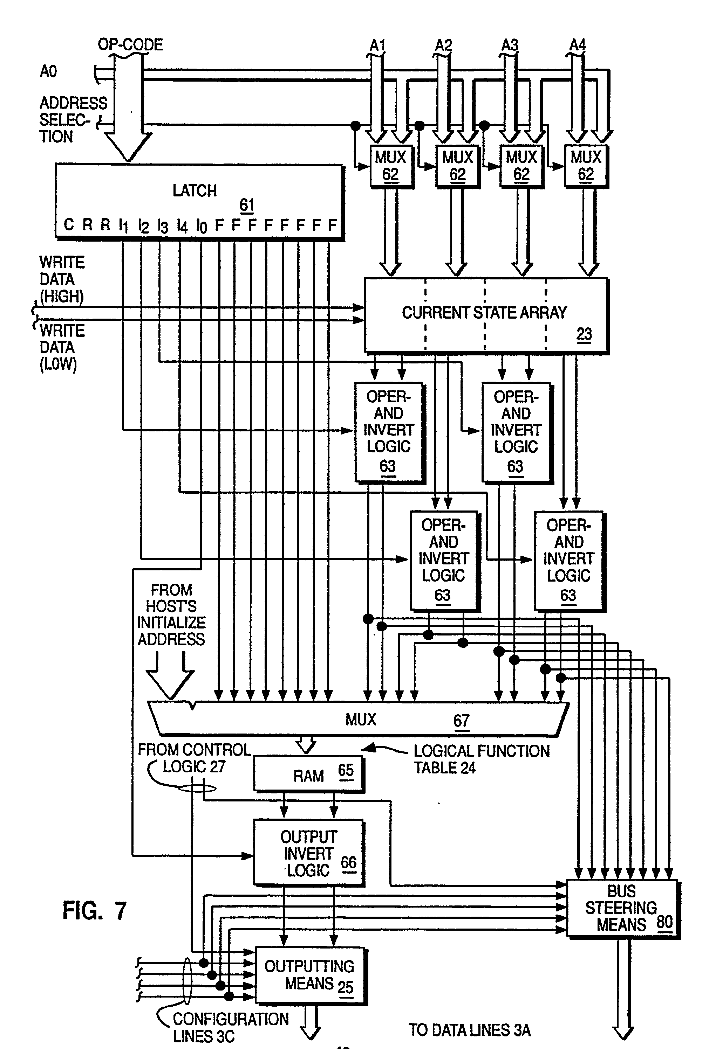

Referring to Fig. 7, the logical function table 24 is explained. The logical function table 24 is a programmable logic block whose main element is a memory 65, a 64K x 2bit static RAM, indexed by the 8-bit function pointer in the op-code field plus the four 2-bit input operands form the operand invert logics 63. The logical function table 24 generates a 2-bit output, which is the next state of the gate being evaluated. The RAM 65 is also accessible to the host computer 5 through a multiplexor 67, which needs to load it with a set of logical functions prior to beginning of the simulation. The logical function table 24 is in essence a look up table which generates a 2-bit output with respect to a given gate function and four input operands. The output of the logic function table 24 is supplied to the outputting means 25 through an output invert logic means 66. The output from the table 24 may be inverted in the output invert logic means 66 by the inversion bit of the op-code before being put on the allocated lines of the data lines 3A through the outputting means 25. The outputs from the operand invert logics 63 are also supplied to the bus steering means 80. When the Broadcast command is executed by the control logic 27, the bus steering means 80 receives four current states designated by A1 thru A4 fields of the command from the current state array 23 through the operand invert logics 63 and puts eight bit data on the data lines 0 thru 7, 8 thru 15, 16 thru 23, or 24 thru 31 under the control of the control logic 27. The data in the current state array 27 are sent to the host 5 by the Broadcast command from the simulation processors 2 for use in the host 5. The Broadcast command is the subject of the co-pending application US Serial No.                filed                and having internal docket No. AT9-89-098.

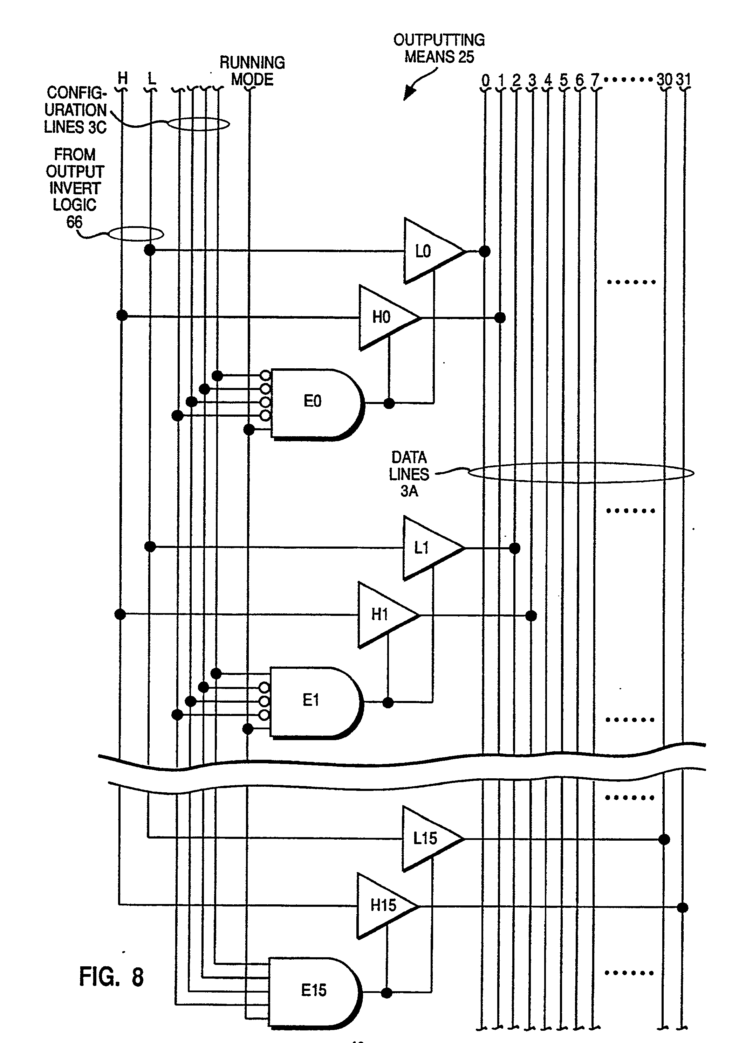

Referring to Fig. 8, the outputting means 25 is explained. The outputting means 25 comprises 16 AND gates E0, E1,..., and E15, 16 gates L0, L1,..., and L15 whose outputs are connected to the even number lines 0, 2,..., and 30 of the data lines 3A, respectively, and 16 gates H0, H1,..., and H15 whose outputs are connected to the odd number lines 1, 3,..., and 31 of the data lines 3A, respectively. The configuration lines 3C which are connected to the hard wired means 3D and the control logic 27 are connected to inputs of the AND gates E0, E1,..., and E15. All inputs from the lines 3C to the gate E0 are inverted so that only the 4-bit binary data 0000 on the lines 3C can activate the gate E0. An input from the least significant bit line of the lines 3C is directly connected to the gate E1 and the other three inputs from the lines 3C to the gate E1 are inverted so that only the 4-bit binary data 0001 can activate the gate E1 and so on. All inputs from the lines 3C are directly connected to the gate E15 so that only the 4-bit binary data 1111 on the lines 3C can activate the gate E15. A running mode signal from the control logic 27 is also connected to input of each of the AND gates E0, E1,..., and E15 to activate the AND gates during running mode of the simulation processors 2. Outputs of the AND gates E0, E1,..., and E15 are connected to enable terminals of the gates L0 and H0, L1 and H1,..., and L15 and H15, respectively. The low bit line of the output from the output invert logic means 66 is connected to inputs of the gates L0, L1,..., and L15. The high bit line of the output from the output invert logic means 66 is connected to inputs of the gates H0, H1,..., and H15. Accordingly, the simulation processors 2 plugged into the slot means 0, 1, 2,..., and 15 put their calculated results on the lines 0 and 1, lines 2 and 3, lines 4 and 5,..., and lines 30 and 31 of the data lines 3A through the outputting means 25, respectively. Thus, each simulation processor 2 is allocated two of the data lines 3A to put its result thereon, depending on which slot means of the simulatiom bus 3 that processor 2 occupies.

Referring back to Fig. 2, the control logic means 27 controls a clock means 68 so that all of the simulation processors 2 connected with the simulation bus means 3 synchronously execute their operations. The control logic means 27 controls the program counter 26 so that the program counter 26 generates addresses to output instructions from the block description array 22 and addresses to write the calculated results from all of the simulation processors 2 into the current state arrays 23. The control logic means 27 control the control instructions, such as Branch, Broadcast, and Halt. The control logic means 27 also controls the simulation processor 2 to load the block description array 22 with instructions and the current state array 23 with initial states from the host computer 5 before simulation.

In addition, the simulation processor 2 occupying the slot 0 contains the host interface 21 to transfer data and instructions between the host 5 and the simulation processors 2. The host interface 21 is a First-In First-Out buffer to buffer data between the simulation bus means 3 and the host I/O bus means 56. When packet data comes from the host through the host interface 21, each of the simulation processors 2 takes its data off the simulation bus means 3. When packet data are sent to the host, control logic in the host interface 21 determines, by the contents of the control lines 3B, that the data on the data lines 3A is intended for the host and transfers the data to the host 5. The host interface means 21 allows the user to initialize the block description array 22 and the current state arrays 23 at the beginning of the simulation and tests results at the end of the simulation. It may also allow the user to read and modify the contents of the current state arrays 23 during the simulation for enhanced simulation capability. The host interface is the subject of the co-pending application US Serial No. _____ filed _____ and having internal docket No. AT9-89-097.

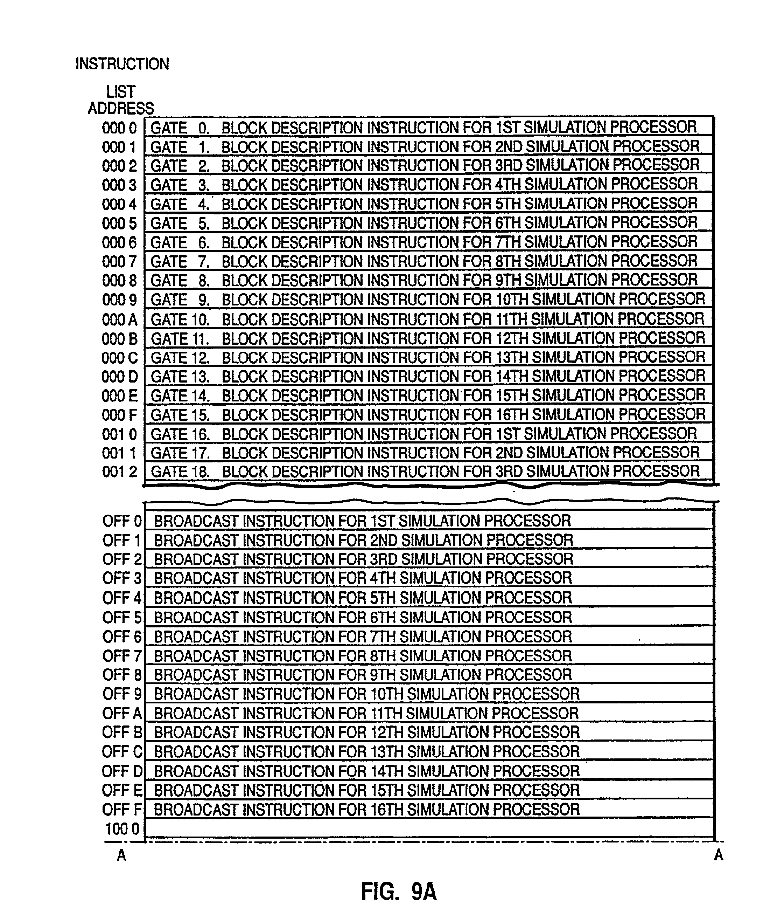

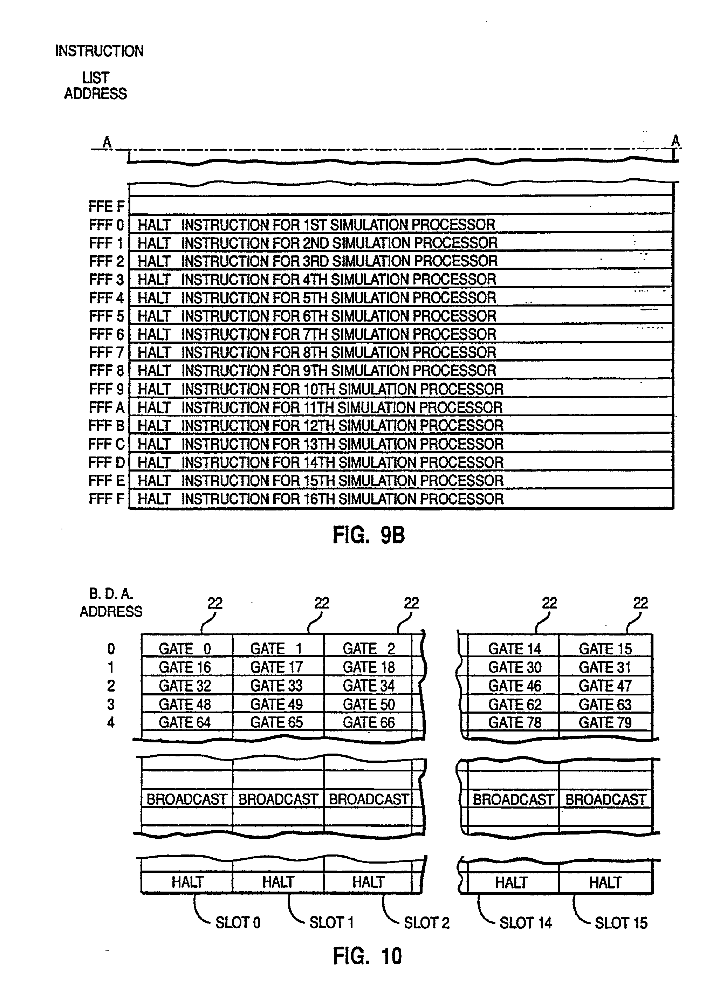

Now, referring to Fig. 9, a method of compiling a model to be simulated by the logic simulation machine 1 of this embodiment is explained. The method comprises assigning the block description instructions of a model to be simulated to each of the simulation processors in "round-robin" fashion in an instruction list to be loaded into the simulation processors 2 from the host computer 5 before a simulation so that the block instructions begin at the first simulation processor, proceed to the 16th processor, and then back to the first processor to repeat the above sequence. The method further comprises inserting a set of 16 identical control instructiors for the processors in the same sequence as the block description instructions at a location beginning at k x 16 (k is an integer) in the instruction list. 16 is the maximum number in the group (1, 2, 4, 8, 16) from which a user can select the number of simulation processors to be installed in the logic simulation machine 1 to get a desired performance. In Fig. 9, block description instructions for each of the simulation processors are arranged by turns, beginning at the first processor, proceeding to the 16th processor, and then backing to the first processor to repeat the above sequence and sets of the same sixteen control instructions are put on locations from 0FF0 (Broadcast), and from FFF0 (Halt). All sixteen instructions in one cycle are to be operated simultaneously by the simulation processors 2 in the largest configuration. Therefore, all block description instructions in the same cycle must be of the same rank. Block description instructions that begin a new logic rank must begin at a location p x 16 (p is an integer) and dead cycles are inserted before the first block of the new rank in order to absorb delay between when an instruction is fetched and when its output is ready due to pipeline operation if the pipeline operation is used. If delayed writeback of computed results is used, that is, if the computed results are written back to the current state array every jth cycle, the new logic rank must begin at a location j x q x 16 (j and q are integers).

Now, referring back to Figs. 1 and 2, the operation of the logic machine 1 is explained. The host computer 5 is used to personalise the simulation processors 2 on power-on operation, load the simulation processors 2 with instructions and data before the simulation, evaluate the results during and/or after the simulation, and interface with user. The host computer 5 personalised each of the simulation processors 2 directly through the I/O bus means 56. On personalisation, the host counts the number of the simulation processors 2 plugged into the I/O slots and tells the simulation processors 2 the mumber. After the personalisation, however, the host does not reed to take care of the configuration of the simulation processors 2 as explained later. After the personalisation, the host computer 5 communicates with the simulation processors 2 only through the host interface 21 provided in the simulation processor 2 plugged into the slot 0 of the simulation bus means 3 except power supply through the I/O slot.

When loading the instructions into the block description array 22 in each of the simulation processors 2 of the machine 1, the host computer 5 sends instructions in the model shown in Fig. 9 sequentially from the top to the bottom of the list to the simulation bus means 3 through the I/O bus 56 and the host interface 21. Each simulation processor 2 takes by turns the instructions having the same lower 4-bit binary address in the list of Fig. 9 as the binary data on the configuration lines 3C associated with the slot means which that processor occupies. That is, the processors plugged into the slots 0, 1, 2,..., and 15 take the instructions having lower 4-bit binary addresses 0000, 0001, 0010,..., and 1111, respectively and store consecutively the instructions in the block description arrays 22 from the first address. Thus, as shown in Fig. 10, the simulation processors 2 plugged into the slot means 0, 1,..., and 15 store consecutively the block description instructions for gates 0, 16, 32,..., gates 1, 17, 33,..., and gates 15, 31, 47,..., in their block description arrays 22, respectively, and store the same control instructions at the same addresses in the block description arrays 22.

Referring back to Figs. 1 and 2 again, the host computer 5 loads the same initial states of a whole model to be simulated by the machine 1 into the current state array 23 in each of the simulation processors 2. In the embodiment, the current state array 23 in each simulation processor 2 maintains a complete copy of current states of the whole model being simulated during the simulation as explained later. The host computer also loads the same functional data into the logical functional table 24.

There are two modes in operation of the simulation, running and stopped. When running mode, each simulation processor 2 continuously steps through its block description array 22, evaluating each gate's next state, until it receives a command to stop that can be either imbedded in the block description array 22 or come from the host computer 5. In the stopped mode, no simulation is occurring, and the entire state of the logic simulation machine 1 including the current state array 23 and the block description array 22 is available for inspection and modification by the host computer 5.

In the running mode, this logic simulation machine 1 allows the sixteen simulation processors 2 to work on one simulation model to speed up simulation. In a parallel configuration, each simulation processor 2 evaluates one gate per cycle. At the end of the cycle each simulation processor 2 puts its result on the allocated lines of the data lines 3A in parallel and all simulation processors 2 update their current state arrays 23 with the results from the data lines 3A.

At each cycle of the running mode, the following steps are synchronously performed in each simulation processor 2 which is plugged into the simulation bus means 3 until a Halt command is found from the block description array 22 or the host computer 5 stops the simulation.

The control logic means 27 sequentially increments the program counter 26 from a start address to sequentially output instructions from the block description array 22. When the block description array 22 is addressed by the program counter 26, it outputs an instruction stored in the corresponding address. The op-code field of the instruction is latched by a latch 61. The op-code field indicates whether it is a block description instruction or a control instruction. If it is a block description instruction, the op-code field describes the function of the gate being evaluated. The fields A1 thru A4 specify four input connections of the gate being evaluated and correspond to addresses in the current state array 23 where the current states of the input connections are stored.

The addresses A1 thru A4 are passed to the array 23 through the multiplexors 62. Four 2-bit current states that are input operands to the gate being evaluated are simultaneously fetched from the addresses designated by the fields A1 thru A4. These input operands are sent to the operand invert logic means 63 so that the operands are inverted if the op-code indicates before the calculation in the logical function table 24.

The input operands to the gate being evaluated are sent to the logical function table 24. This information, along with the function pointer of the op-code field describing the gate's function from the latch 61, serves as a pointer into the logical function table 24. The logical function table 24 is in essence a look up table, and generates a proper 2-bit output value for the gate given its present inputs.

The output of the logical function table 24 is sent to the output invert logic 66 so that the output is inverted if the op-code indicates. The result from the output invert logic means 66 is supplied to the outputting means 25 to be put on the allocated lines of the data lines 3A in order to update all the current state arrays 23 in the machine 1 with the result.

For example, the AND gate shown in Fig. 5 is evaluated as follows: The program counter 26 of the simulation processor plugged into the slot 0 generates an address Z to fetch the block description instruction of the gate from the block description array 22. Four operands H(0,1), H(0,1), L(0,0), and L(0,0) are fetched from the addresses V, W, X, and Y in the current state array 23 as designated by the fields A1 thru A4 of the block description instruction. The first and the second input operands H(0,1) and H(0,1) are inverted to L(0,0) and L(0,0) in the operand invert logic 63 by the op-code. All four L(0,0) input operands and an function pointer specifying AND function are inputted to the table 24. The table 24 outputs a result, L(0,0). This result is inverted to H(0,1) in the output invert logic means 66 by the op-code. The output H(0,1) is supplied to the outputting means to transfer to all the simulation processors 2 to update their current state arrays 23.

As explained before, the processors 2 in the slot 0, 1, 2,..., and 15 put their 2-bit results on the allocated lines 0 and 1, 2 and 3, 4 and 5,..., and 30 and 31 of the data lines 3A, respectively. In this way, all results calculated in this cycle appear on the data lines 3A in parallel. The results on the data lines 3A are received by the control logic means 27 and are written back to 16 adjacent addresses beginning at an address designated by the product of the simulation cycle number and the number of the simulation processors in the configuration (16 in this embodiment), in the current state array 23 in each of the processors 2 at the end of each simulation cycle. For example, at the end of the first simulation cycle, addresses 0 thru 15 in the current state array 23 in each simulation processors are updated with results on the data lines 3A. At the end of second simulation cycle, addresses 16 thru 31 in the current state array 23 are updated with results on the lines 3A. At the end of the third simulation cycle, addresses 32 thru 47 and so on. In this way, the current state array 23 in each simulation processor 2 is updated with the results calculated at each simulation cycle by all of the processors 2 and keeps a complete copy of current states of the model being evaluated in the machine 1. The host computer 5 can receive the results through the data lines 3A and the host interface 21 during the simulation by the broadcast command and/or after the simulation from the current state array 23 of the processor 2 plugged into the slot 0.

When the simulation processors 2 execue the control instructions, Branch, Broadcast, Halt, etc., the identical control instructions are executed simultaneously in all of the simulation processors 2 for proper synchronization of the simulation. For, example, Branches are resolved identically across all simulation processors 2 at a time.

In this embodiment, plural similation processors 2 work on a simulation model in parallel to speed up the simulation, this allows an almost linear speedup, that is, twice as many simulation processors run twice as fast. The non-linearity of the speedup is only due to the updating requirement, since a higher proportion of time will be spent writing data back into the current state arrays. Although 16 simulation processors 2 are connected with the simulation bus means 3 in this embodiment, any number of simulation processors selected from the group consisting of 1, 2, 4, 8, and 16 is able to be connected with the simulation bus means 3 depending on a desired performance. The configuration of the simulation processors 2 is kept transparent from the host computer 5 and the same model built for the largest configuration as shown in Fig. 9 can be used irrespective of the changes in the configuration because the control logic 27 and the configuration lines 3C inform the simulation processors of the configuration to take care of the configuration change by themselves. And after the personalisation of the simulation processors 2, the host computer 5 communicates with the logic simulation machine 1 through the host interface 21 of the processor 2 plugged into the slot 0 of the simulation bus means 3. Then, the group of the simulation processors 2 appear to the host computer 5 as a single entity with respect to a number of tasks; building the simulation model, loading it into the simulator, running the simulation, and retrieving the results for analysis.

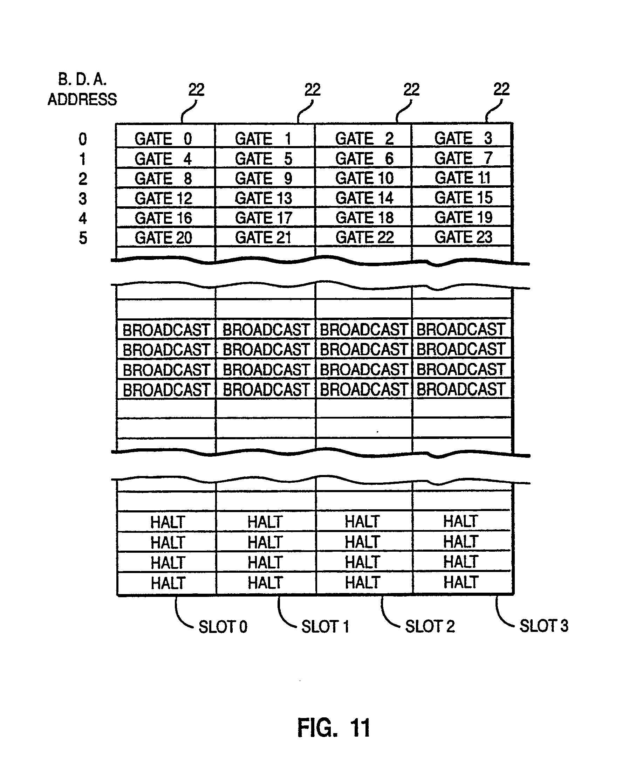

If four simulation processors 2 are connected with the simulation bus means 3 instead of sixteen simulation processors, the four simulation processors 2 are plugged into the slots 0, 1, 2, and 3 and receive unique data from the configuration lines 3C, respectively. When loading of the model of Fig. 9 into the block description array 22 of each of the simulation processors 2, each simulation processor 2 receives the instructions having the same lower 2-bit binary address in the list of Fig. 9 as the lower 2-bit data of the unique data on the configuration lines 3C. Thus, the processors 2 in the slot 0, 1, 2, and 3 receive the instructions having the lower two-bit binary addresses 00, 01, 10, and 11, respectively and store them into the block description array 22 consecutively as shown in Fig. 11. Four gates are evaluated at one simulation cycle in this configuration. The results of the four gates evaluated by the four processors 2 are put on the lines 0 thru 7 of the data lines 3A in parallel at the end of the first cycle of every four cycles, on the lines 8 thru 15 at the end of the second cycle of every four cycles, on the lines 16 thru 23 at the end of the third cycle of every four cycle, and on the lines 24 thru 31 at the end of the forth cycle of every four cycle. This is done by sending from the control logic 27 (0,0) at the first cycle, (0,1) at the second cycle, (1,0) at the third cycle, and (1,1) at the forth cycle on the most and the second significant bit lines of the configuration lines 3C in Fig. 8 . At the end of the forth cycle, all the data lines 3A have the results and the results are written back to sixteen adjacent addresses in the current state array 23 beginning at an address designated by the product of the first simulation cycle number of every four cycles and the number of the simulation processors, that is, four. Namely, at the end of every four cycles when all the data lines 3B are filled with the results from the processors 2, the current state array 23 in each of the simulation processors 2 are updated with the results on the data lines 3B. This configuration needs four simulation cycles to evaluate the same sixteen gates while the configuration of Fig. 1 needs one simulation cycle. In the four processor configuration as shown in Fig. 11, each block description array 22 has four identical control instructions in four adjacent addresses. Each control logic means 27 in the processor 2 executes the first Branch or Halt control instruction of the four identical control instructions and neglects the other three redundant identical control instructions since the four Branch or Halt commands have the same contents. However, all the Broadcast control instructions are executed by the processors 2 since each of the sixteen Broadcast command contains different operands in the fields A1 thru A4 to transfer data from the arrays 23 to the host 5.

The embodiment makes the number of simulation processors transparent to software. This means that architecturally 16 block description instructions are always exected simultaneously. In fact, this may take 1, 2, 4, 8, or 16 cycles, depending on the number of the simulation processors, but the software does not see a difference. When the host computer accesses the block description arrays in the simulation processors for loading or other purposes, it sees simply one set of instructions. Physically, the hardware of the simulation processors may direct the host's accesses to different arrays on multiple cards, but the host does not see this. If a logic model to be simulated is built for the largest configuration of the logic similation machine the model will run on any smaller configuration without any modification. This concept allows the same model to be used across many hardware configurations. The host does not need to know the configuration but just sends all host data to the I/O bus regardless of the configuration. This is important particularly because the architecture of this embodiment allows the user to reconfigure the logic simulation machine at any time in order to get a desired performance.

In the simulation, the simulation processors 2 will normally be used to simulate only gate logic, functions such as memory or array modelling and device behavioural will be performed by the host computer 5. However, in the embodiment shown in Fig. 1, all data to and from the host computer 5 goes on the simulation bus means 3, the host becomes just another device on the bus 3. This implies that any host function can be done by a hardware accelerator or an auxiliary processor which is connected to the simulation bus means 3 in parallel with the simulation processors 2 by mimicking the traffic on the simulation bus 3. Obvious candidates for the hardware accelerator or the auxiliary processor is trace collection, memory or array simulation, and device behavioural, where the host may be slowing down the simulation throughput. In fact, all functions except user interface could be migrated to an auxiliary processor to relieve such a host work.

The all events trace (AET) gatherer 4 is an example of such an auxiliary processor. An all events trace (AET) is a record of what has happened to all of the facilities during a simulation. AET data is normally collected by having the host computer 5 evaluate all of the nodes to be traced at the end of each simulation cycle in the prior art. Even with the efficiencies of the Broadcast command to send only those nodes of interest to the host, two limitations remain. First all of the nodes to be traced are sent to the host computer, ever those that did not change. Second, it places a considerable time requirement on the host to evaluate the data every simulation cycle. The AET gatherer 4 generates an AET data in parallel with the simulation to relieve the host task.

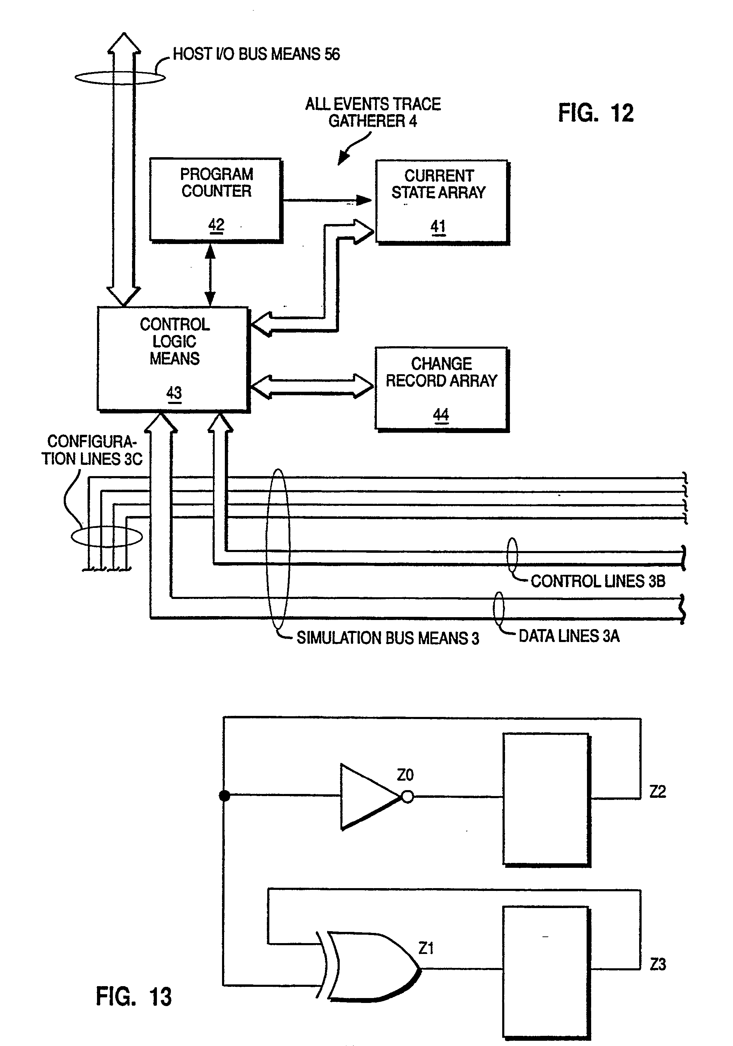

Referring to Fig. 12, the AET gatherer 4 is explained. The AET gatherer 4 has the same components as those of the simulation processor 2, that is, a current state array 41 that keeps a complete copy of current states of the whole model being simulated by monitoring the simulation bus means 3 and a program counter 42 which is synchronised with the simulation processor 2. In addition, the AET gatherer 4 has its control logic means 43 and a change record array 44 to store only changes in the model being simulated.

At the beginning of each simulation cycle, the control logic 43 puts a marker in the change record array 44 to indicate the cycle begin point. As simulation progresses, the control logic 43 monitors the simulation bus means 3 to keep a complete copy of the current states in the current state array 41. By comparing the new values of each node address as they are generated against the old value in the current state array 23, the control logic 43 detects a change in the node. Whenever a change is detected, the control logic 43 stores the node address and new node value in the change record array 44.

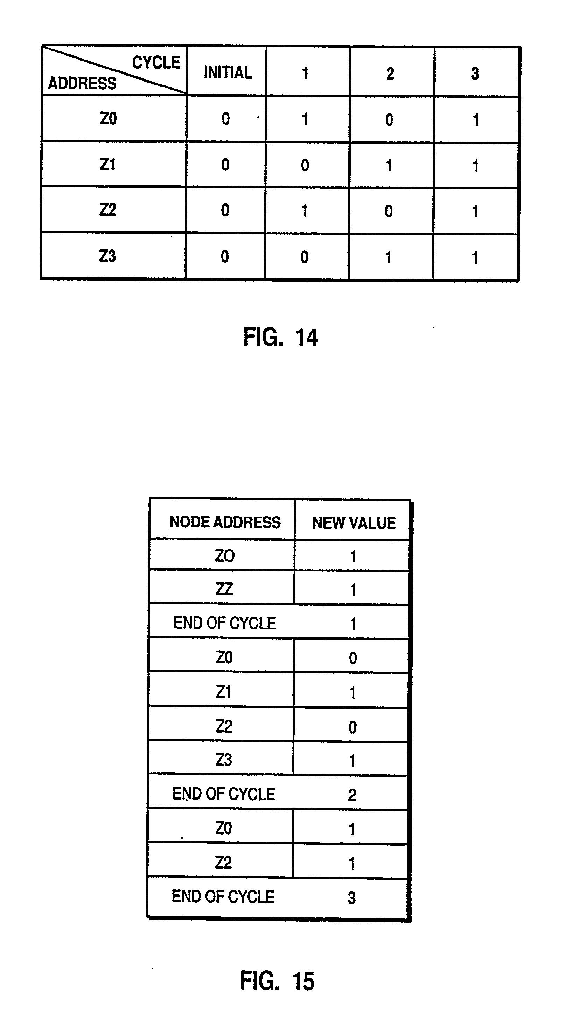

Referring to Figs. 13, 14 and 15, operation of the AET gatherer 4 is explained. Fig. 13 shows a design model, a two-bit counter, to be simulated by the simulation processors 2 in the logic simulation machine 1. There are four nodes Z0, Z1, Z2 and Z3 to be evaluated. Fig. 14 shows the states of all the nodes in the current state array 41 at the end of each simulation cycle, all nodes in the model having been evaluated once. Fig. 15 shows the contents of the change record array 44 after three simulation cycles. Only changed modes and new values are stored in the change record array 44.

A subset of all facilities can be traced by keeping another (shadow) array equal in size to the current state array 41 that is used as a mask. A bit must be on the shadow array for the node to be traced.

The AET gatherer 4 is a passive auxiliary processor which only monitors the simulation bus means 3. The only time it affects the simulation is if it must halt simulation to dump the change record array 44 to the host. This should happen rarely if ever, and can be avoided entirely if the host has bandwidth to handle both the simulation and AET dump. Since AET gatherer 4 is recording a minimum of information (changes only), if the change record array 44 is large enough and the number of facilities to be traced is reasonable, most simulation cases can be completed before the AET dump is required. The AET gatherer 4 generates the AET by monitoring the simulation bus 3 without slowing down the tasks of the simulation processors and of the host computer and also allows any subset of the facilities to be collected by using the shadow array storing a mask which indicates which nodes are to be traced. The AET gatherer is the subject of the co-pending application US Serial No. _____ filed _____ having internal docket No. AT9-89-096.

In the preferred embodiment shown in Fig. 1, the number of the simulation processors connected with the simulation bus means is $2^n$ and the maximum is sixteen. However, the invention does not limit the number of the simulation processors to $2^n$ and the maximum number is not limited to sixteen in the invention. Any plural number of the simulation processors can be connected with the simulation bus means in the invention so as to allocate data lines of the bus means to each of the simulation processors in order to put results thereon in parallel and to maintain a complete copy of current states of a whole model being simulated.

According to the logic simulation machine and the method of simulation of the invention, as with the Cocke et al. patent, each simulation processor simulates a set of logic gates. However, it is different in that each simulation processor maintains a complete copy of the simulated machine state, and, in place of the inter-processor switch, there is provided a simulation bus means over which updates to the simulated machine state are broadcast. This information is used by each individual simulation processor to update its own copy of the simulated machine state. The simulation bus means comprises individual data lines that contain the calculated results for each of the simulation processors. Thus, as a whole, it contains all of the calculated results of all of the simulation processors. In the machine where there are s processors and each processor's calculated result is expressed by the states of t lines, the simulation bus means contains s x t data lines.

Although the cost of implementing a complete copy of the simulated machine state in each processor is higher than the scheme employed in the prior art, there are a number of factors that offset the disadvantage. First, the cost of memory has declined significantly in recent years. Secondly, the inter-processor switch is a complex and expensive piece that is not necessary in this machine. Thirdly, the difficulties in compiling and scheduling a logic model to be simulated in the prior art switch-based machine do not exist in this machine. This saves significant expense in actual use of simulator. Finally, the architecture allows duplication of the machine state in other auxiliary processors by simply connecting the auxiliary processors to the simulation bus means, allowing these to participate in the simulation process. The auxiliary processors might be used for such tasks as simulating memory arrays and collecting trace information about the simulation to provide simulation speedup.

Another characteristic that distinguishes the invention from the prior art is the way in which it connects to the host computer. It is intended that all of the simulation processors directly plug into the I/O bus of the host computer. It is further intended that the group of simulation processors appear to the host computer as a single entity, and that it can operate the simulation processor in the same manner, independent of the number of the simulation processors. This includes a number of tasks; compiling the simulation model, loading the model into the simulator, and the running simulation.

A further characteristic of the interaction between the host computer and the simulation processor is that the host computer will, in some configurations, perform portions of the simulation. The most common examples of this activity are modelling arrays and taking trace information.

While the invention has been particularly shown and described with reference to preferred embodiments thereof, it will be understood by those skilled in the art that changes in form and details may be made therein without departing from the spirit and scope of the invention.

## Claims

1. A logic simulation machine comprising: a plurality of simulation processors for executing logic simulation in parallel characterised by a simulation bus connecting the simulation processors to each other, the simulation bus including a plurality of data lines allocated to each of the simulation processors for parallel transfer of information from each of the simulation processors.

2. A machine as claimed in claim 1 wherein each simulation processor includes a memory adapted to keep a copy of current states of a model being simulated by receiving information from said data lines.

3. A machine as claimed in claimed 1 or claim 2 according to claim 1 including a host computer connected to said simulation bus by means of a host interface on said bus, said host computer being adapted to compile a simulation model and to broadcast data representing such model to all simulator processors over said simulation bus.

4. A machines as claimed in claim 3 in which said host computer is adapted to perform portions of a simulation.

5. A machine as claimed in claim 3 or claim 4 including an auxiliary processor connected to said simulators bus and arranged to accelerate simulation by sharing processing of data with the host computer.

6. A machine as claimed in any preceding claim, in which each simulation processor includes, a first memory for storing instructions necessary to specify operations of the simulation processor, a second memory for storing current states of a whole model being simulated, and a logical function table connected with the first and second memory means for calculating a result from the instruction and the current states, said data lines including lines connected to transfer the result to all the simulation processors so that all the second memory units of the simulation processors keep the same current states of the whole model being simulated.

7. A machine as claimed in any preceding claim in which said simulation bus is physically configured to provided a plurality of slots into which the simulation processors are plugged, and includes a plurality of configuration lines energisable to identify each of the simulation processors with a performed slot.

8. A method of operating an array of simulation processors in order to simulate the behaviour of a logic model characterised by developing a simulation model in a host computer and loading data representing such model the data lines to each of the simultaneously into all simulation processors over a parallel simulation bus connecting said host computer to all of said simulation processors.

9. A method as claimed in claim 8 wherein an auxiliary processor includes a memory unit, further characterised by first storing a copy of initial state of whole model to be simulated in the memory unit in each of the simulation processors; and subsequently updating the copy stored in the memory unit with information on said simulation bus in each of the simulation processors as simulations proceeds.

10. A method as claimed in claim 8 or claim 9 for use with an array of simulation processors, each having a first memory means, a second memory means, and a logical function table, comprising the steps of: allocating a set of the data lines to each of the simulation processors; storing instructions necessary to specify operations of each of the simulation processors in the first memory means of each of the simulation processors; storing initial states of a whole model to be simulated in the second memory means of each of the simulation processors; addressing the first memory means to output a stored instruction in each of the simulation processors; addressing the second memory means based on the instruction from the first memory means to output the stored states in each of the simulation processors; calculating a result from the outputted instruction and the outputted states in the logical function table in each of the simulation processors; putting the result from the logical function table on the data lines allocated to each of the simulation processors in parallel in each of the simulation processors; and updating the second memory means with the results from the data lines in each of the simulation processors so that all of the second memory means in the simulation processors store the same current states of the whole model being simulated.

FIG. 1A

FIG. 1B

FIG. 2

BLOCK DESCRIPTION ARRAY 22

| ADDRESS | OP-CODE (16) | A1 (24) | A2 (24) | A3 (24) | A4 (24) |
|---|---|---|---|---|---|
| 000 | OP-CODE | A1 | A2 | A3 | A4 |
| 001 | | | | | |
| 010 | | | | | |
| 011 | | | | | |
| Z | AND | V | W | X | Y |
| | HALT | | | | |

**FIG. 3**

OP - CODE

| Bits | Description |
|---|---|
| 1 | BLOCK DESCRIPTION |
| R R | RESERVED |
| I1 | INVERT OPERAND 1 |
| I2 | INVERT OPERAND 2 |
| I3 | INVERT OPERAND 3 |
| I4 | INVERT OPERAND 4 |
| I0 | INVERT OUTPUT |
| F F F F F F F F | FUNCTIONAL POINTER |
| 0 | CONTROL INSTRUCTION |
| r r x x x x x 0 0 x x x x x x | HALT |
| I1 I2 I3 I4 x 0 1 | BROADCAST END |
| I1 I2 I3 I4 x 1 0 | BROADCAST |
| I1 I2 x x I0 1 1 f f f f f f | BRANCH |

**FIG. 4**

V — H
W — H
X — L
Y — L
Z — H

**FIG. 5**

16

FIG. 6

EP 0 450 837 A2

EP 0 450 837 A2

FIG. 7

FIG. 8

INSTRUCTION

LIST
ADDRESS

| | |
|---|---|
| 000 0 | GATE 0. BLOCK DESCRIPTION INSTRUCTION FOR 1ST SIMULATION PROCESSOR |
| 000 1 | GATE 1. BLOCK DESCRIPTION INSTRUCTION FOR 2ND SIMULATION PROCESSOR |
| 000 2 | GATE 2. BLOCK DESCRIPTION INSTRUCTION FOR 3RD SIMULATION PROCESSOR |
| 000 3 | GATE 3. BLOCK DESCRIPTION INSTRUCTION FOR 4TH SIMULATION PROCESSOR |
| 000 4 | GATE 4. BLOCK DESCRIPTION INSTRUCTION FOR 5TH SIMULATION PROCESSOR |
| 000 5 | GATE 5. BLOCK DESCRIPTION INSTRUCTION FOR 6TH SIMULATION PROCESSOR |
| 000 6 | GATE 6. BLOCK DESCRIPTION INSTRUCTION FOR 7TH SIMULATION PROCESSOR |
| 000 7 | GATE 7. BLOCK DESCRIPTION INSTRUCTION FOR 8TH SIMULATION PROCESSOR |
| 000 8 | GATE 8. BLOCK DESCRIPTION INSTRUCTION FOR 9TH SIMULATION PROCESSOR |
| 000 9 | GATE 9. BLOCK DESCRIPTION INSTRUCTION FOR 10TH SIMULATION PROCESSOR |
| 000 A | GATE 10. BLOCK DESCRIPTION INSTRUCTION FOR 11TH SIMULATION PROCESSOR |
| 000 B | GATE 11. BLOCK DESCRIPTION INSTRUCTION FOR 12TH SIMULATION PROCESSOR |
| 000 C | GATE 12. BLOCK DESCRIPTION INSTRUCTION FOR 13TH SIMULATION PROCESSOR |
| 000 D | GATE 13. BLOCK DESCRIPTION INSTRUCTION FOR 14TH SIMULATION PROCESSOR |
| 000 E | GATE 14. BLOCK DESCRIPTION INSTRUCTION FOR 15TH SIMULATION PROCESSOR |
| 000 F | GATE 15. BLOCK DESCRIPTION INSTRUCTION FOR 16TH SIMULATION PROCESSOR |
| 001 0 | GATE 16. BLOCK DESCRIPTION INSTRUCTION FOR 1ST SIMULATION PROCESSOR |
| 001 1 | GATE 17. BLOCK DESCRIPTION INSTRUCTION FOR 2ND SIMULATION PROCESSOR |
| 001 2 | GATE 18. BLOCK DESCRIPTION INSTRUCTION FOR 3RD SIMULATION PROCESSOR |

| | |
|---|---|
| OFF 0 | BROADCAST INSTRUCTION FOR 1ST SIMULATION PROCESSOR |
| OFF 1 | BROADCAST INSTRUCTION FOR 2ND SIMULATION PROCESSOR |
| OFF 2 | BROADCAST INSTRUCTION FOR 3RD SIMULATION PROCESSOR |
| OFF 3 | BROADCAST INSTRUCTION FOR 4TH SIMULATION PROCESSOR |
| OFF 4 | BROADCAST INSTRUCTION FOR 5TH SIMULATION PROCESSOR |
| OFF 5 | BROADCAST INSTRUCTION FOR 6TH SIMULATION PROCESSOR |
| OFF 6 | BROADCAST INSTRUCTION FOR 7TH SIMULATION PROCESSOR |
| OFF 7 | BROADCAST INSTRUCTION FOR 8TH SIMULATION PROCESSOR |
| OFF 8 | BROADCAST INSTRUCTION FOR 9TH SIMULATION PROCESSOR |
| OFF 9 | BROADCAST INSTRUCTION FOR 10TH SIMULATION PROCESSOR |
| OFF A | BROADCAST INSTRUCTION FOR 11TH SIMULATION PROCESSOR |
| OFF B | BROADCAST INSTRUCTION FOR 12TH SIMULATION PROCESSOR |
| OFF C | BROADCAST INSTRUCTION FOR 13TH SIMULATION PROCESSOR |
| OFF D | BROADCAST INSTRUCTION FOR 14TH SIMULATION PROCESSOR |
| OFF E | BROADCAST INSTRUCTION FOR 15TH SIMULATION PROCESSOR |
| OFF F | BROADCAST INSTRUCTION FOR 16TH SIMULATION PROCESSOR |
| 100 0 | |

A                                                                                                   A

## FIG. 9A

INSTRUCTION

LIST
ADDRESS

| | |
|---|---|
| A | A |
| FFE F | |
| FFF 0 | HALT   INSTRUCTION FOR 1ST SIMULATION PROCESSOR |
| FFF 1 | HALT   INSTRUCTION FOR 2ND SIMULATION PROCESSOR |
| FFF 2 | HALT   INSTRUCTION FOR 3RD SIMULATION PROCESSOR |
| FFF 3 | HALT   INSTRUCTION FOR 4TH SIMULATION PROCESSOR |
| FFF 4 | HALT   INSTRUCTION FOR 5TH SIMULATION PROCESSOR |
| FFF 5 | HALT   INSTRUCTION FOR 6TH SIMULATION PROCESSOR |
| FFF 6 | HALT   INSTRUCTION FOR 7TH SIMULATION PROCESSOR |
| FFF 7 | HALT   INSTRUCTION FOR 8TH SIMULATION PROCESSOR |
| FFF 8 | HALT   INSTRUCTION FOR 9TH SIMULATION PROCESSOR |
| FFF 9 | HALT   INSTRUCTION FOR 10TH SIMULATION PROCESSOR |
| FFF A | HALT   INSTRUCTION FOR 11TH SIMULATION PROCESSOR |
| FFF B | HALT   INSTRUCTION FOR 12TH SIMULATION PROCESSOR |
| FFF C | HALT   INSTRUCTION FOR 13TH SIMULATION PROCESSOR |
| FFF D | HALT   INSTRUCTION FOR 14TH SIMULATION PROCESSOR |
| FFF E | HALT   INSTRUCTION FOR 15TH SIMULATION PROCESSOR |
| FFF F | HALT   INSTRUCTION FOR 16TH SIMULATION PROCESSOR |

## FIG. 9B

B. D. A.
ADDRESS

| | 22 | 22 | 22 | | 22 | 22 |
|---|---|---|---|---|---|---|
| 0 | GATE  0 | GATE  1 | GATE  2 | | GATE 14 | GATE 15 |
| 1 | GATE 16 | GATE 17 | GATE 18 | | GATE 30 | GATE 31 |
| 2 | GATE 32 | GATE 33 | GATE 34 | | GATE 46 | GATE 47 |
| 3 | GATE 48 | GATE 49 | GATE 50 | | GATE 62 | GATE 63 |
| 4 | GATE 64 | GATE 65 | GATE 66 | | GATE 78 | GATE 79 |

| | | | | | |
|---|---|---|---|---|---|
| BROADCAST | BROADCAST | BROADCAST | | BROADCAST | BROADCAST |

| | | | | | |
|---|---|---|---|---|---|
| HALT | HALT | HALT | | HALT | HALT |

SLOT 0    SLOT 1    SLOT 2       SLOT 14    SLOT 15

## FIG. 10

| B. D. A.<br>ADDRESS | 22 | 22 | 22 | 22 |
|---|---|---|---|---|
| 0 | GATE 0 | GATE 1 | GATE 2 | GATE 3 |
| 1 | GATE 4 | GATE 5 | GATE 6 | GATE 7 |
| 2 | GATE 8 | GATE 9 | GATE 10 | GATE 11 |
| 3 | GATE 12 | GATE 13 | GATE 14 | GATE 15 |
| 4 | GATE 16 | GATE 17 | GATE 18 | GATE 19 |
| 5 | GATE 20 | GATE 21 | GATE 22 | GATE 23 |

| BROADCAST | BROADCAST | BROADCAST | BROADCAST |
|---|---|---|---|
| BROADCAST | BROADCAST | BROADCAST | BROADCAST |
| BROADCAST | BROADCAST | BROADCAST | BROADCAST |
| BROADCAST | BROADCAST | BROADCAST | BROADCAST |

| HALT | HALT | HALT | HALT |
|---|---|---|---|
| HALT | HALT | HALT | HALT |
| HALT | HALT | HALT | HALT |
| HALT | HALT | HALT | HALT |

SLOT 0   SLOT 1   SLOT 2   SLOT 3

# FIG. 11

FIG. 12

HOST I/O BUS MEANS 56

ALL EVENTS TRACE GATHERER 4

PROGRAM COUNTER 42

CURRENT STATE ARRAY 41

CONTROL LOGIC MEANS 43

CHANGE RECORD ARRAY 44

CONFIGURATION LINES 3C

CONTROL LINES 3B

SIMULATION BUS MEANS 3

DATA LINES 3A

FIG. 13

Z0

Z1

Z2

Z3

| CYCLE ADDRESS | INITIAL | 1 | 2 | 3 |
|---|---|---|---|---|
| Z0 | 0 | 1 | 0 | 1 |
| Z1 | 0 | 0 | 1 | 1 |
| Z2 | 0 | 1 | 0 | 1 |
| Z3 | 0 | 0 | 1 | 1 |

FIG. 14

| NODE ADDRESS | NEW VALUE |
|---|---|
| Z0 | 1 |
| ZZ | 1 |
| END OF CYCLE | 1 |
| Z0 | 0 |
| Z1 | 1 |
| Z2 | 0 |
| Z3 | 1 |
| END OF CYCLE | 2 |
| Z0 | 1 |
| Z2 | 1 |
| END OF CYCLE | 3 |

FIG. 15